# FASCICULE DE BREVET EUROPEEN

(11) **EP 2 948 987 B1**
(45) Date de publication et mention de la délivrance du brevet: **11.08.2021**
(21) Numéro de dépôt: 14701369.2
(22) Date de dépôt: 24.01.2014
(51) Int. Cl.: H01L 33/00, H01L 33/06, H01L 33/08, H01L 21/02

(54) **PROCÉDÉ DE FABRICATION D'UNE DIODE ÉLECTROLUMINESCENTE ET DIODE ÉLECTROLUMINESCENTE**
VERFAHREN ZUR HERSTELLUNG EINER LEUCHTDIODE UND LEUCHTDIODE
METHOD FOR FABRICATING A LIGHT EMITTING DIODE AND LIGHT EMITTING DIODE

(30) Priorité: 24.01.2013 FR 1350621
(43) Date de publication de la demande: 02.12.2015
(73) Titulaire: Centre National de la Recherche Scientifique (C.N.R.S.), 75016 Paris (FR)
(72) Inventeur: NATAF, Gilles, F-06220 Golfe Juan (FR); DE MIERRY, Philippe, F-06560 Valbonne (FR); CHENOT, Sébastien, F-06250 Mougins (FR)
(74) Mandataire: Marks & Clerk France
(86) Numéro de dépôt international: PCT/EP2014/051366
(87) Numéro de publication internationale: WO 2014/114731

(56) Documents cités:
- DE-A1-102010 029 916
- JP-A- 2003 303 993
- US-A1- 2010 148 147

## Description

### DOMAINE DE L'INVENTION

L'invention concerne le domaine technique des diodes électroluminescentes et de leur procédé de fabrication associé. Notamment, la présente invention concerne le domaine des diodes électroluminescentes émettant une lumière blanche.

### PRÉSENTATION DE L'ART ANTÉRIEUR

On connaît du document US 2006/0049415 des diodes électroluminescentes monolithiques adaptées pour émettre une lumière dans le domaine du visible, comme par exemple une lumière blanche ou une lumière de couleur prédéterminée.

Une telle diode électroluminescente monolithique comprend :
- un substrat de saphir 1,
- une couche tampon 2A, 2B de nitrure de gallium (dénommée « GaN » dans la suite) sur le substrat de saphir 1,
- une couche 2C de nitrure de gallium dopée n (dénommée « n-GaN » dans la suite) sur la couche tampon de GaN,
- un contact métallique 3 sur la couche de n-GaN 2C,
- un empilement 4 de puits quantiques de type nitrure d'indium et de gallium InGaN (dénommé « InGaN » dans la suite) et de couches barrières de GaN,
- une couche 6 de nitrure de gallium dopée p (dénommée « p-GaN » dans la suite) sur l'empilement GaN/InGaN,
- un contact métallique 7 sur la couche de p-GaN 6.

L'empilement de puits quantiques est composé d'une superposition alternée de puits quantiques émettant dans le bleu (4B, 4K, 4M) ou dans le vert (4D, 4F, 4H) et de couches barrières de GaN (4A, 4C, 4E, 4G, 4J, 4L, 4N). Cet empilement de puits quantiques émettant dans des couleurs différentes permet d'obtenir une lumière blanche.

Toutefois, la qualité du blanc obtenu (ou « CRI », sigle de l'expression anglo-saxonne « Color Rendering Index ») est médiocre, du fait que le rendement quantique interne des puits quantiques émettant dans le vert est inférieur à celui des puits quantiques émettant dans le bleu. Il en résulte une couleur « blanchâtre » tirant vers le bleu. Ce phénomène est accentué lorsqu'on augmente le courant d'injection afin d'augmenter la puissance optique de la diode : il est donc très difficile de contrôler le spectre d'électroluminescence de telles diodes dont les puits quantiques ne sont soumis qu'à une source d'excitation électrique unique. Enfin, il est très difficile de créer un empilement de puits quantiques émettant à des longueurs d'onde différentes sans dégrader l'ensemble de la structure ainsi empilée du fait de l'augmentation des cycles de température nécessaires à la réalisation d'un tel empilement. En particulier, la dernière étape de fabrication de la diode, à savoir la formation d'une couche p sur l'empilement de puits quantiques peut dégrader les puits quantiques à forte teneur en indium (puits verts) car cette couche p est épitaxiée habituellement à des températures supérieures à 1000°C.

On connaît aussi du JP2003303993 A des diodes électroluminescentes monolithiques comprenant une couche émettrice de lumière sur une face avant d'un support, ladite couche émettrice comprenant deux puits quantiques adjacent émettant à des longueurs d'onde différentes. Pendant l'étape de dépôt de ladite couche émettrice, la température d'une face arrière du support opposée à la face avant est variée localement de sorte que la face avant du support comporte deux zones à des températures différentes.

Un but de la présente invention est de proposer un nouveau type de diode électroluminescente, et un nouveau procédé de fabrication associé permettant de pallier au moins l'un des inconvénients précités.

### RÉSUMÉ DE L'INVENTION

A cet effet, l'invention propose un procédé de fabrication d'une diode électroluminescente selon revendication 1.

On entend, dans le cadre de la présente invention, par « *puits quantiques adjacents »,* au moins deux types de puits quantiques émettant à des longueurs d'onde différentes, disposés côte à côte et non empilés, c'est-à-dire disposés à un même niveau selon un axe de croissance A-A' de la diode électroluminescente, lesdits puits quantiques étant préférentiellement en contact l'un avec l'autre.

Le fait que l'étape de dépôt de la couche émettrice de lumière comprend une sous-étape consistant à faire varier localement la température à la surface du support de sorte que la face avant du support comporte au moins trois zones à des températures différentes permet de faire varier la quantité d'indium incorporée dans les puits quantiques formés sur chacune des zones de températures différentes.

Des aspects préférés mais non limitatifs du procédé décrit ci-dessus sont les suivants :
- l'étape de dépôt de la couche émettrice comprend une sous-étape consistant à faire croître chaque puits quantique sur une zone respective ; avantageusement, un même support peut comprendre plusieurs zones à une première température, et plusieurs zones à une deuxième température, deux zones en regard à la première température étant séparées par une zone à la deuxième température,
- la sous-étape consistant à faire varier localement la température de chauffage du support consiste à chauffer le support sous sa face arrière, ledit support incluant au moins un îlot sur sa face arrière ;
   ceci permet d'obtenir un support incluant des régions de températures différentes,
- le procédé comprend une étape de préparation du support consistant à réaliser au moins un motif sur la face arrière du support ;
- l'étape de préparation du support consiste à réaliser une pluralité de motifs pour obtenir un support présentant une face arrière crénelée incluant des marches ;
- l'étape de préparation du support consiste à réaliser une pluralité de motifs pour obtenir un support présentant une face arrière crénelée incluant des marches d'épaisseurs et/ou de surfaces différentes ;
- l'étape de préparation comprend la gravure du support sur sa face arrière pour créer au moins une tranchée ;
- l'étape de préparation comprend le dépôt d'un matériau sur la face arrière du support de sorte à créer au moins un îlot sur la face arrière du support ;
- le procédé comprend en outre les étapes suivantes :
   - le dépôt d'une couche de transport d'électrons sur un substrat,
   - le dépôt d'une couche de blocage des électrons (ou *« electron blocking layer »* en anglo-saxon) - telle qu'une couche de nitrure de gallium et d'aluminium AlGaN - sur la couche émettrice de lumière,
   - le dépôt d'une couche de transport de trous sur la couche émettrice de lumière,
   - la formation de contacts métalliques pour permettre la connexion de la diode à une source d'alimentation électrique ;

Avantageusement, la croissance de chaque puits quantique peut être réalisée par:
- épitaxie en phase vapeur aux organométalliques à partir de précurseurs gazeux d'indium, d'aluminium, de gallium et d'azote, ou par
- épitaxie par jet moléculaire à partir de sources élémentaires comprenant de l'indium, de l'aluminium, du gallium et de l'azote.

L'invention concerne également une diode électroluminescente selon revendication 11.

Des aspects préférés mais non limitatifs de la diode décrite ci-dessus sont les suivants :
- le support comprend un substrat de nitrure de gallium GaN, tel qu'un substrat de nitrure de gallium GaN polaire semi-polaire ou non-polaire ;
- la diode comprend une couche métallique formant cathode sur toute la surface de la face arrière de la diode.

### BREVE DESCRIPTION DES DESSINS

D'autres avantages et caractéristiques du procédé selon l'invention et du produit associé ressortiront mieux de la description qui va suivre de plusieurs variantes d'exécution, données à titre d'exemples non limitatifs, à partir des dessins annexés sur lesquels :
- la figure 1 illustre un exemple de diode monolithique de l'art antérieur, constituée d'un empilement vertical de puits quantiques ;
- les figures 2 à 4 illustrent des exemples de diodes électroluminescentes, constitués de puits quantiques répartis latéralement sur la surface.
- la figure 5 illustre en vue de dessus un exemple de couche émettrice de lumière comprenant des puits quantiques concentriques ;
- la figure 6 illustre schématiquement un exemple de procédé de fabrication d'une diode électroluminescente,
- les figures 7 et 10 illustrent des variantes de phase de préparation de la face arrière d'un substrat conformément à l'invention,
- les figures 8 et 9 illustrent des exemples de substrats de départ préparés,

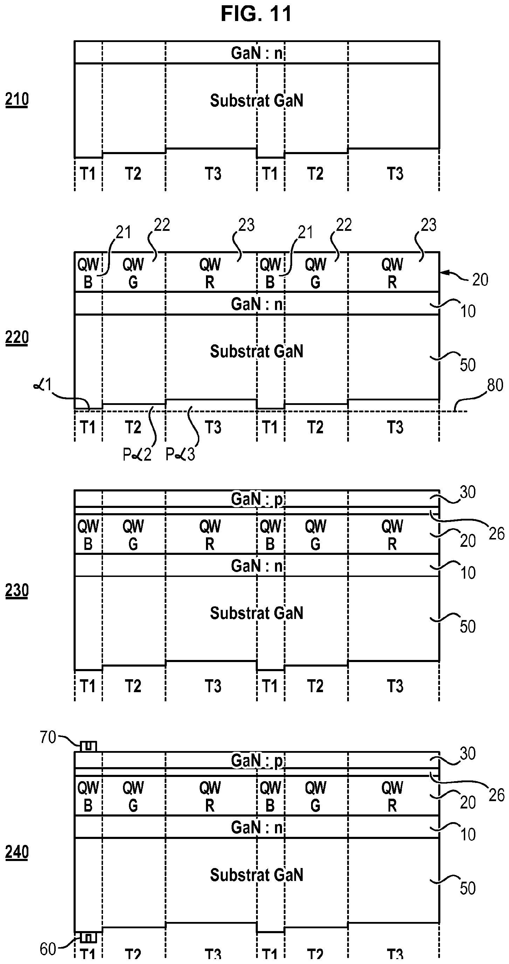

- la figure 11 illustre un exemple de phase d'élaboration d'éléments composant une diode électroluminescente conformément à l'invention,
- les figures 12 et 13 illustrent des spectres obtenus par photoluminescence,
- la figure 14 illustre des spectres obtenus par cathodoluminescence.

### DESCRIPTION DÉTAILLÉE DE L'INVENTION

On va maintenant décrire plus en détail des exemples de diodes électroluminescentes seulement illustratives ou selon l'invention ainsi que des procédés de fabrication de telles diodes.

### 1. Diode électroluminescente

### 1.1. Structure générale

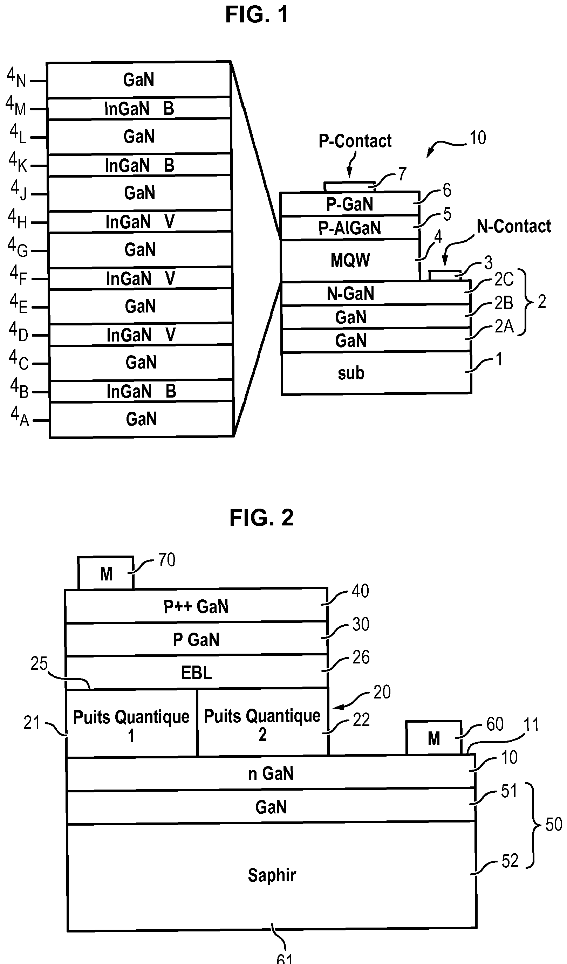

En référence aux figures 2 à 4, on a illustré trois variantes de diodes électroluminescentes émettant une lumière blanche.

Ces diodes électroluminescentes comprennent :
- une couche de transport d'électrons 10 dopée n, telle qu'une couche n-GaN de nitrure de gallium dopé n,
- un ensemble de puits quantiques 20 sur la couche de transport d'électrons 10,
- Une couche de blocage d'électrons 26 (EBL) telle qu'une couche de nitrure de gallium et d'aluminium AlGaN. Cette couche peut être dopée de type p ou non dopée,
- une couche de transport de trous 30 dopée p, telle qu'une couche p-GaN de nitrure de gallium dopé p sur l'ensemble de puits quantiques, et éventuellement
- une couche p++ GaN de nitrure de gallium 40 dopé p++ (i.e. plus fortement dopée p que la couche p-GaN) sur la couche de transport de trous 30.

### 1.2. Substrat de départ

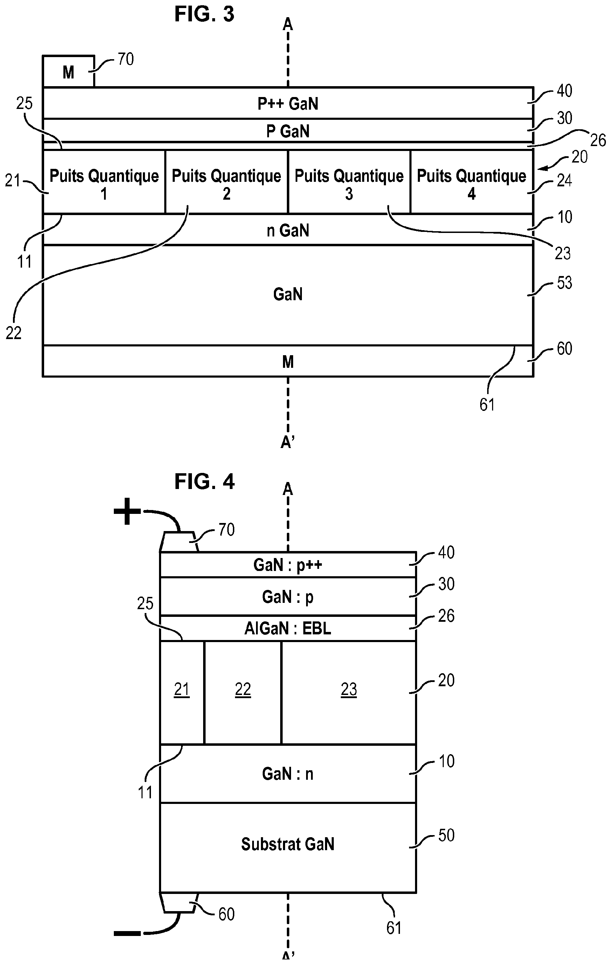

Dans les modes de réalisation illustrés aux figures 2 et 3, les diodes électroluminescentes comprennent également un substrat de départ 50 supportant les couches de transport 10, 30, l'ensemble de puits quantiques 20, une couche de blocage d'électrons 26 d'AlGaN et la couche p++GaN 40. Ce substrat de départ 50 est utilisé pour l'élaboration des diodes électroluminescentes, comme il sera décrit plus en détail dans la suite.

Dans le mode de réalisation illustré à la figure 2, le substrat de départ 50 est composé d'un film de nitrure de gallium 51 sur une plaque de saphir 52. Dans le cas de la figure 3, le substrat de départ 50 est une couche de nitrure de gallium autosupportée 53.

L'homme du métier appréciera que, dans le cas de la diode illustrée aux figures 3 et 4, c'est la couche de transport d'électrons 10 qui fait office de substrat de départ à l'élaboration d'une diode électroluminescente.

### 1.3. Premier contact métallique formant cathode

Dans tous les cas, les diodes comprennent un premier contact métallique 60 formant cathode. Ce premier contact métallique 60 est destiné à être relié à une borne négative d'une source d'alimentation électrique (non représentée) pour l'alimentation électrique de la diode électroluminescente, et plus précisément pour l'alimentation en électrons de la couche de transport d'électrons 10.

Dans le mode de réalisation illustré à la figure 2, le premier contact métallique 60 est formé sur la face avant 11 de la couche de transport d'électrons 10, la plaque de saphir 52 étant isolante électriquement.

Dans les modes de réalisation illustrés aux figures 3 et 4, le premier contact métallique 60 est positionné sur la face arrière 61 de la diode électroluminescente. Plus particulièrement :
- le premier contact métallique 60 s'étend sur la face arrière du substrat de nitrure de gallium GaN autosupporté 53 dans le mode de réalisation illustré à la figure 3,
- le premier contact métallique 60 s'étend sur la face arrière de la couche de transport d'électrons 10 dans mode de réalisation illustré à la figure 4.

En effet, dans le cas de la figure 3, le substrat est du GaN autosupporté non intentionnellement dopé. Il est donc nécessaire d'effectuer une reprise d'épitaxie GaN dopé Si (type n) sur un tel substrat. Dans le cas de la figure 4, le substrat autosupporté est déjà dopé n. Il joue donc le rôle de transport d'électrons en plus de celui de substrat. Ce dernier cas est le plus avantageux, pour un transport d'électrons optimisé vers la couche p.

L'utilisation d'un substrat de départ à base de nitrure de gallium (couche de transport d'électrons n-GaN ou couche de GaN autosupportée) permet de positionner le premier contact métallique 60 sur la face arrière 61 de la diode. On diminue ainsi la résistance série de la diode, comparée à la structure de la figure 2 et on limite ainsi les pertes de courant par échauffement, ce qui améliore le rendement lumineux de telles diodes électroluminescentes.

Par ailleurs, lorsque le substrat de départ est à base de nitrure de gallium, le premier contact métallique 60 peut avantageusement être réalisé sur toute la surface de la face arrière 61 de la diode (comme illustré à la figure 3) pour améliorer encore le rendement lumineux de celle-ci - par réflexion du flux de photons émis par la couche émettrice de lumière vers la face avant de la diode.

### 1.4. Ensemble de puits quantiques

L'ensemble de puits quantiques 20 s'étend sur la face avant 11 de la couche de transport d'électrons 10. Cet ensemble de puits quantiques 20 est composé de « n » puits quantiques, « n » étant un entier naturel égal à 2, ou selon l'invention supérieur ou égal à 3:
- dans le mode de réalisation illustré à la figure 2, et ne faisant pas partie de l'invention telle que revendiquée l'ensemble de puits quantiques est composé de deux puits quantiques 21, 22 ;
- dans le mode de réalisation illustré à la figure 4, conformément à l'invention l'ensemble de puits quantiques est composé de trois puits quantiques 21, 22, 23 ;
- dans le mode de réalisation illustré à la figure 3, conformément à l'invention l'ensemble de puits quantiques est composé de quatre puits quantiques 21, 22, 23, 24.

Dans tous les cas, les puits quantiques 21, 22, 23, 24 d'un ensemble 20 sont adjacents, c'est-à-dire qu'ils sont disposés côte-à-côte sur la face avant 11 de la couche de transport d'électrons 10.

Chaque puits quantique 21, 22, 23, 24 est composé d'au moins une couche de nitrure de gallium aluminium indium InₓAl_{y}Ga_{1-x-y}N dont les concentrations en indium et/ou aluminium et/ou gallium varient d'un puits quantique à l'autre.

Ainsi, chaque puits quantique 21, 22, 23, 24 est adapté pour émettre une lumière à une (ou plusieurs) longueur(s) d'onde donnée(s), de sorte que chacun des puits quantiques émet une lumière de couleur différente. L'ensemble de puits quantique adjacents (ou séquence de puits) doit de préférence être circonscrit dans le périmètre de la diode. En d'autres termes, la dimension latérale de cette séquence de puits doit être inférieure aux dimensions communes des diodes qui sont comprises entre 100 µm et 1 mm.

Dans la variante de réalisation illustrée à la figure 4, un premier puits quantique 21 est adapté pour émettre une lumière bleue, un deuxième puits quantique 22 est adapté pour émettre une lumière verte, et un troisième puits quantique 23 est adapté pour émettre une lumière rouge.

Dans la variante de réalisation illustrée à la figure 2, un premier puits quantique 21 est adapté pour émettre une lumière bleue, et un deuxième puits quantique 22 est adapté pour émettre une lumière verte. Dans la variante de réalisation illustrée à la figure 4, les quatre puits quantique 21, 22, 23, 24 émettent des lumières de couleurs respectives bleue, verte, rouge et jaune.

Dans tous les cas, le mélange des lumières de différentes couleurs (rouge, vert, bleue, jaune, etc.) émises par un ensemble de puits quantiques 20 permet d'émettre une lumière composite de couleur prédéterminée, et notamment une lumière blanche.

Les dimensions latérales de chaque puits quantique 21, 22, 23, 24 dépendent de la couleur composite désirée. En effet, la couleur composite est fonction de l'intensité de la lumière émise par chaque puits quantique.

Par exemple, pour les couleurs rouge, verte et bleue, il est connu que :
- le rendement lumineux d'un puits quantique émettant dans le bleu est supérieur au rendement lumineux d'un puits quantique émettant dans le vert,
- le rendement lumineux d'un puits quantique émettant dans le vert est supérieur au rendement lumineux d'un puits quantique rouge.

Donc, pour émettre une lumière composite blanche à partir de puits quantiques 21, 22, 23 émettant des lumières de ces trois couleurs :
- les dimensions du puits quantique émettant dans le bleu 21 seront inférieures aux dimensions du puits quantique émettant dans le vert 22, et
- les dimensions du puits quantique émettant dans le vert 22 seront inférieures aux dimensions du puits quantique émettant dans le rouge 23.

Les dimensions des puits quantiques 21, 22, 23, 24 d'un ensemble de puits quantiques 20 seront donc déterminées en fonction de l'application visée.

Il en va de même de la forme des différents puits quantiques.

Dans les modes de réalisation illustrés aux figures 2 à 4, chaque puits quantique de l'ensemble de puits quantiques est de forme parallélépipédique.

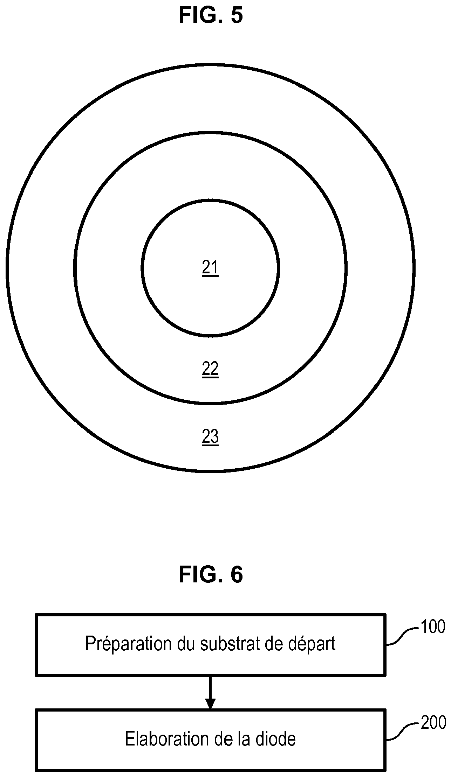

En variante, les puits quantiques peuvent être de forme cylindrique comme illustré à la figure 5.

Dans ce mode de réalisation, l'ensemble de puits quantiques comprend :
- un premier puits quantique 21 de forme cylindrique et adapté pour émettre une lumière bleue,
- un deuxième puits quantique 22 en forme de tube cylindrique s'étendant à la périphérie du premier puits quantique 21, ce deuxième puits quantique 22 étant adapté pour émettre une lumière verte, et
- un troisième puits quantique 23 en forme de tube cylindrique s'étendant à la périphérie du deuxième puits quantique 22, ce troisième puits quantique 23 étant adapté pour émettre une lumière rouge.

### 1.5. Couche de transport de trous, couche p++ GAN et deuxième contact métallique

Comme décrit ci-dessus, la diode comprend également :
- une couche de blocage d'électrons 26, telle qu'une couche de nitrure de gallium et aluminium AlGaN et
- une couche de transport de trous 30, telle qu'une couche de nitrure de gallium dopée p.

Cette couche de transport de trous 30 s'étend sur toute la surface de la couche de blocage d'électrons 26 déposée sur la face avant 25 de l'ensemble de puits quantiques 20. Les couches de transport d'électrons 10 et de trous 30 forment les couches d'injection électrique de la diode.

C'est pourquoi, la couche de transport de trous 30 est destinée à être connectée à la borne positive de la source d'alimentation électrique (non représentée), et ceci par l'intermédiaire d'un deuxième contact métallique 70 formant anode.

Ce deuxième contact métallique 70 peut être :
- directement en contact avec la couche de transport de trous 30, ou
- en contact avec une couche intermédiaire p++GaN 40 s'étendant sur toute la surface de la face avant de la couche de transport de trous, comme illustré aux figures 2 à 4.

Cette couche intermédiaire p++GaN 40c fortement dopée p présente des caractéristiques de conductivité électrique proche de celle d'un métal.

L'utilisation d'une telle couche p++ GaN permet une meilleure répartition des charges issues de la source d'alimentation électrique sur toute la surface de la couche de transport de trous 30.

Le contact métallique p est généralement constitué d'un plot métallique épais (quelques centaines de nm) 70, et d'une fine (une dizaine de nm) couche métallique recouvrant toute la surface p de la diode. Elle a pour fonction de répartir de façon homogène les lignes de courant afin que la recombinaison radiative des pairs électron-trous dans les puits et donc le flux de photons soit réparti de façon homogène sur toute la surface de la diode.

On va maintenant décrire différents exemples de procédés permettant l'obtention de diodes électroluminescentes. Ces exemples de procédés seront décrits en référence à la fabrication d'une diode comprenant des puits quantiques émettant des lumières de couleurs bleue, verte et rouge.

### 2. Procédé de fabrication

### 2.1. Principe général

La (ou les) longueur(s) d'onde(s) de la lumière émise par un puits quantique de nitrure de gallium et d'indium In GaN dépend(ent) de la température locale à laquelle ledit puits quantique a été réalisé.

En effet, la couleur de la lumière émise par un puits quantique dépend de sa concentration en indium.

Or, l'incorporation d'indium dans un puits quantique est elle-même dépendante de la température locale à laquelle le puits quantique a été élaboré : plus la température d'élaboration du puits quantique est basse, plus la concentration en indium dans la couche formant le puits quantique est importante.

Ainsi, la température d'élaboration d'un puits quantique émettant dans le bleu est supérieure à la température d'élaboration d'un puits quantique émettant dans le vert. De même, la température d'élaboration d'un puits quantique émettant dans le vert est supérieure à la température d'élaboration d'un puits quantique émettant dans le rouge.

Pour la fabrication d'une diode comprenant une pluralité de puits quantiques adjacents émettant des lumières de couleurs différentes, les procédés décrits dans la suite proposent de faire varier localement la température de surface de la face avant du support sur lequel est réalisée la pluralité de puits quantiques.

Ceci permet d'obtenir une couche émettrice de lumière comprenant une pluralité de puits quantiques adjacents émettant à des longueurs d'ondes différentes, lesdits puits quantiques étant en contact avec la face avant du support.

### 2.2. Modes de réalisation de procédés de fabrication

On a illustré à la figure 6 un exemple de procédé de fabrication d'une diode électroluminescente comprenant une couche émettrice de lumière 20 constituée de puits quantiques adjacents 21, 22, 23, 24 émettant à des longueurs d'ondes différentes.

Une première phase 100 du procédé consiste à préparer le substrat de départ 50 sur lequel la diode électroluminescente est fabriquée.

Une deuxième phase 200 du procédé consiste à élaborer la diode électroluminescente proprement dite.

Cette deuxième phase est réalisée dans un réacteur de croissance en phase vapeur.

Un tel réacteur fonctionne sur le principe général suivant. Le substrat de départ 50 est disposé sur la face supérieure d'un suscepteur 80. Ce suscepteur 80 comprend des éléments chauffants (non représentés) permettant le chauffage de la face supérieure du suscepteur 80, et donc du substrat de départ 50. Des précurseurs sont conduits jusqu'au substrat de départ par un gaz vecteur. Au contact du substrat de départ chauffé, le gaz se décompose alors par pyrolyse en alimentant la croissance du dépôt.

Ainsi, dans les réacteurs de croissance en phase vapeur conventionnelle, le chauffage du substrat de départ est obtenu en chauffant le suscepteur 80 sur lequel il repose.

Dans certains modes de réalisation, le procédé de fabrication utilise ce principe général pour faire varier localement la température du substrat sur lequel est élaborée la diode électroluminescente.

Notamment, la première phase du procédé de fabrication consiste à former des marches (ou motifs) sur la face arrière du substrat pour induire une variation de la température de la face avant du substrat au droit desdites marches.

### 2.2.1. Préparation du substrat

Comme indiqué précédemment, le substrat de départ 50 peut être de différents types.

Par exemple, le substrat de départ 50 peut comprendre :
- un film de nitrure de gallium GaN 51 sur une plaque de saphir 52, ou encore
- une couche de nitrure de gallium autosupportée 53.

La couche (respectivement le film) de nitrure de gallium peut être polaire, semi-polaire ou non-polaire.

L'utilisation de nitrure de gallium polaire rend plus difficile l'élaboration d'un puits quantique émettant une lumière de couleur rouge et ayant un rendement lumineux important. En effet, la présence d'une polarité dans le nitrure de gallium GaN utilisé pour élaborer un puits quantique induit un champ électrique dans le puits qui diminue l'énergie de transition électron-trou et donc décale la longueur d'onde d'émission vers des grandes valeurs de longueur d'onde, ce qui est bénéfique pour obtenir la couleur rouge par exemple. Mais dans le même temps, la présence de ce champs électrique réduit considérablement le rendement lumineux du fait que l'électron dans la bande de conduction et le trou dans la bande de valence sont spatialement éloignés l'un de l'autre de part et d'autre du puits quantique (effet Stark). Ce décalage de la longueur d'onde d'émission vers le rouge et la diminution du rendement lumineux du puits quantique sont d'autant plus importants que l'épaisseur du puits quantique augmente. Pour réaliser un puits quantique émettant dans le rouge, et augmenter le recouvrement des fonctions d'onde de l'électron et du trou (améliorer le rendement lumineux) en utilisant un substrat de nitrure de gallium polaire, il est donc nécessaire de réaliser un puits quantique de faible épaisseur (meilleur recouvrement des fonctions d'onde), tout en augmentant la teneur en indium dans l'alliage InGaN. Or la qualité structurale des puits à forte teneur en indium se dégrade, ce qui conduit également à un rendement lumineux faible.

L'utilisation de nitrure de gallium non-polaire (aucune polarité) ou semi-polaire (dont la polarité est 10 fois inférieure à celle du nitrure de gallium polaire) permet de s'affranchir de l'effet Stark. En l'absence de champ électrique, le recouvrement des fonctions d'onde de l'électron et du trou dans le puits est amélioré, ce qui favorise un plus fort rendement lumineux. Par ailleurs, il est établi que le taux d'incorporation d'indium est plus élevé dans les nitrures semi et non polaire. Ces orientations sont donc favorables à l'obtention de puits quantiques à grandes longueurs d'onde d'émission et fort rendement lumineux.

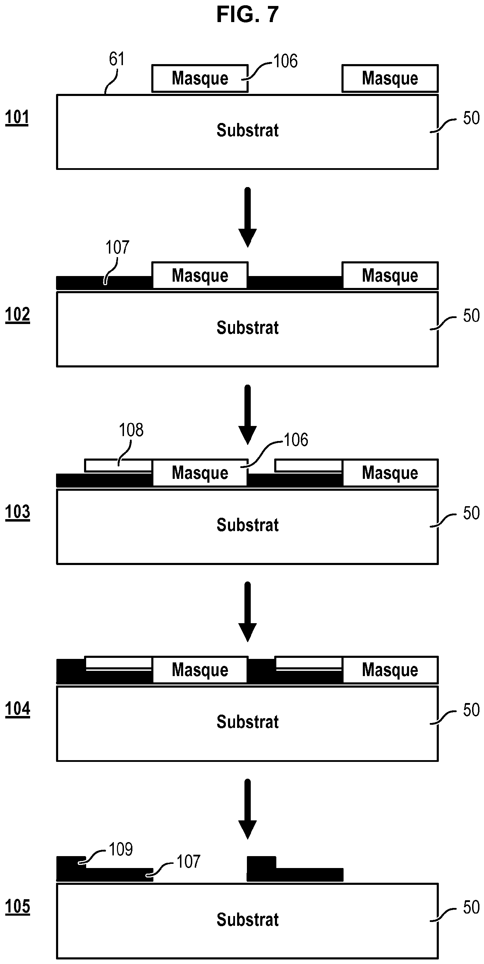

En référence à la figure 7 on a illustré une première variante de préparation du substrat permettant de réaliser des marches sur la face arrière de celui-ci.

Dans cet exemple, le substrat est destiné à être utilisé pour la fabrication de diodes comprenant chacune des puits quantiques émettant des lumières bleue, verte et rouge.

Un premier masque 106 est déposé (étape 101) sur la face arrière 61 du substrat de départ 50. Des puits quantiques émettant de la lumière de couleur rouge seront élaborés au droit des régions recouvertes par le premier masque.

Le dépôt du premier masque 106 peut être réalisé en effectuant un dépôt de résine sur toute la surface de la face arrière du substrat, et en révélant des bandes correspondant aux ouvertures de celui-ci.

Un premier dépôt métallique (étape 102) est mis en œuvre dans les ouvertures du premier masque. Ceci induit la formation de bandes métalliques 107 d'une première épaisseur s'étendant sur la face arrière du substrat de départ 50. La première épaisseur des bandes métalliques 107 dépend de la couleur d'émission souhaitée pour chaque puits quantique.

Un deuxième masque 108 (étape 103) est déposé de sorte à recouvrir une portion des ouvertures du premier masque 106. Des puits quantiques émettant de la lumière de couleur bleue seront élaborés au droit des régions non recouvertes par les premiers et deuxièmes masques 106, 108.

Le dépôt du deuxième masque 108 peut être réalisé en effectuant un nouveau dépôt de résine sur toute la surface de la face arrière du substrat de départ 50, et en révélant des bandes correspondant aux ouvertures du deuxième masque.

Un deuxième dépôt métallique (étape 104) est mis en œuvre dans les ouvertures du deuxième masque. On obtient des bandes métalliques 109 d'une deuxième épaisseur s'étendant dans les ouvertures du deuxième masque 108. Là encore, la deuxième épaisseur de métal déposé est fonction des longueurs d'onde d'émission souhaitées pour les puits quantiques.

Les premier et deuxième masques 106, 108 sont retirés (étape 105).

On obtient un substrat de départ dont la face arrière crénelée comporte des marches constituées :
- par des zones supportant des bandes métalliques 109 de deuxième épaisseur,
- par des zones supportant des bandes métalliques 107 de première épaisseur inférieure à la deuxième épaisseur, et
- par des zones dépourvues de bandes métalliques.

Ce substrat de départ 50 est ensuite placé dans un réacteur pour la mise en œuvre de la deuxième phase d'élaboration de la diode.

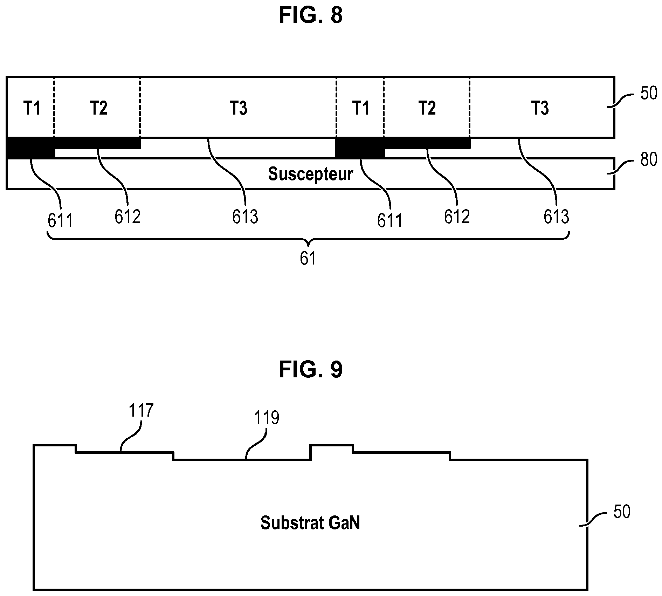

Comme illustré à la figure 8, la face arrière crènelée est en contact avec le suscepteur chauffant 80.

Les zones 611 de la face arrière où s'étendent les bandes de deuxième épaisseur sont en contact avec le suscepteur, tandis que les autres zones 612, 613 (i.e. zones 613 dépourvues de bandes et zones 612 où s'étendent les bandes de première épaisseur) sont plus ou moins éloignées du suscepteur.

Ainsi, la température locale du substrat de départ varie en fonction de sa zone associée :
- les portions du substrat situées au droit des zones 611 sont à une première température T1, des puits quantiques émettant une lumière de couleur bleue seront par exemple élaborés au droit de ces zones 611,
- les portions du substrat situées au droit des zones 612 sont à une deuxième température T2, des puits quantiques émettant une lumière de couleur verte seront par exemple élaborés au droit de ces zones 612,
- les portions du substrat situées au droit des zones 613 sont à une troisième température T3, des puits quantiques émettant une lumière de couleur rouge seront par exemple élaborés au droit de ces zones 613.

L'homme du métier appréciera que le matériau déposé sur la face arrière du substrat pour former les bandes d'épaisseurs différentes ne se limite pas au métal. D'autres matériaux thermo-conducteurs tels que la silice peuvent être utilisés.

En variante, un matériau thermo-isolant peut être déposé sur la face arrière du substrat de départ. Dans ce cas, le matériau thermo-isolant est déposé sur les zones du substrat de départ au droit desquelles on souhaite élaborer des puits quantiques de forte concentration en indium (i.e. puits quantique émettant une lumière de couleur rouge et verte), les zones au droit desquelles on souhaite élaborer des puits quantiques émettant à de faibles longueurs d'ondes étant dépourvues de matériau thermo-isolant.

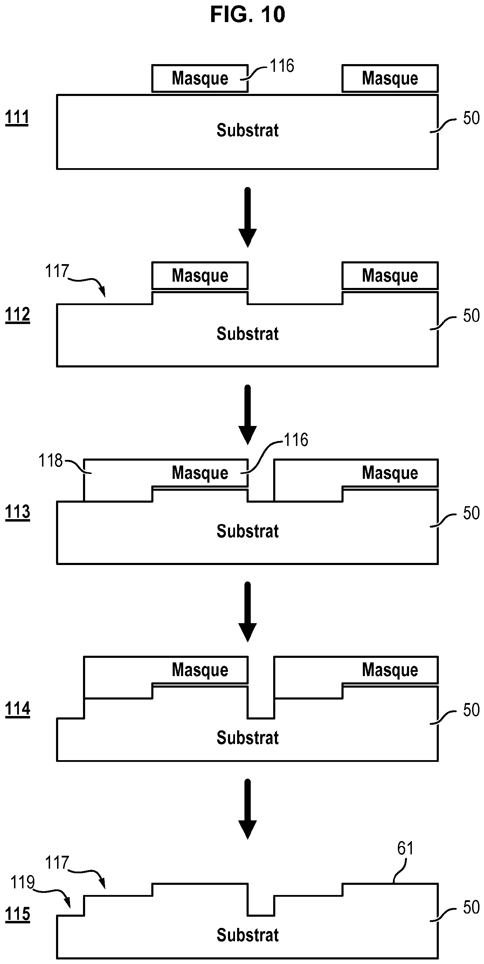

En référence à la figure 10, on a illustré une autre variante de préparation du substrat de départ 50. Dans cette variante, plutôt que de déposer un matériau sur la face arrière du substrat de départ 50 pour former les marches, le substrat de départ 50 est gravé.

On dépose (étape 111) un premier masque 116 sur la face arrière du substrat de départ 50. Des puits quantiques émettant de la lumière de couleur bleue seront élaborés au droit des zones recouvertes par le premier masque.

Le dépôt du premier masque 116 peut être obtenu par dépôt d'une couche de résine et révélation de bandes formant les ouvertures du premier masque.

Une gravure (étape 112) du substrat de départ est mise en œuvre à travers les ouvertures du premier masque 116. Ceci induit la formation de tranchée 117 d'une première profondeur dans la face arrière du substrat de départ 50.

Un deuxième masque 118 recouvrant en partie les ouvertures du premier masque 116 est déposé (étape 113). Des puits quantiques émettant de la lumière de couleur rouge seront élaborés au droit des ouvertures des premiers et deuxièmes masques.

Le dépôt du deuxième masque 118 peut être réalisé en effectuant un nouveau dépôt de résine sur toute la surface de la face arrière du substrat de départ 50, et en révélant des bandes correspondant aux ouvertures du deuxième masque 118.

Une deuxième gravure (étape 114) est réalisée dans les ouvertures du deuxième masque 118. On obtient des tranchées 119 d'une deuxième profondeur dans le substrat de départ 50.

Les premier et deuxième masques 116, 118 sont retirés (étape 115).

On obtient un substrat de départ 50 tel qu'illustré à la figure 9 dont la face arrière crénelée comporte des marches constituées :
- par des zones comportant des tranchées 119 de deuxième profondeur,
- par des zones supportant des tranchées 117 de première profondeur inférieure à la deuxième profondeur, et
- par des zones dépourvues de tranchées.

Tout comme pour la variante de réalisation illustrée à la figure 7, les première et deuxième profondeurs des tranchées sont fonction des longueurs d'onde d'émission souhaitées pour les puits quantiques.

### 2.2.2. Elaboration de diodes

Le substrat de départ 50 préparé est disposé sur un suscepteur d'un réacteur de croissance en phase vapeur.

Une couche de transport d'électrons dopée n - telle qu'une couche de nitrure de gallium n-GaN dopé n - est déposée sur le substrat de départ 50 (étape 210).

Le dépôt de la couche de transport d'électrons est par exemple réalisée soit par épitaxie en phase vapeur aux organométalliques (EPVOM), soit par épitaxie par jet moléculaire (EJM).

On élabore ensuite l'ensemble de puits quantiques 20 (étape 220).

Du fait des marches présentes sur la face arrière du substrat de départ 50, les températures locales au droit de ces marches varient à la surface de la couche de transport 10 :
- les marches en contact avec le suscepteur (distance d1 nulle entre le suscepteur et le substrat) conduisent efficacement la chaleur produite par les éléments chauffants du suscepteur à travers le substrat et la couche de transport d'électrons de sorte que les volumes de matériau situés au droit des zones du substrat en contact avec le suscepteur 80 sont à une température T1 ;
- les marches espacées d'une distance d2 du suscepteur 80 conduisent la chaleur produite par les éléments chauffants moins efficacement (du fait de la distance d2 entre le suscepteur 80 et le substrat 50) de sorte que les volumes de matériau s'étendant au droit des zones espacées d'une distance d2 sont à une température T2 inférieure à T1 ;
- les marches espacées d'une distance d3 (supérieure à d2) du suscepteur 80 conduisent encore moins efficacement la chaleur produite par les éléments chauffants du suscepteur 80 de sorte que les volumes de matériau s'étendant au droit des zones espacées d'une distance d3 sont à une température T3 inférieure à T2.

L'élaboration des puits quantiques est mise en œuvre par épitaxie en phase vapeur aux organométalliques à partir de précurseurs gazeux d'indium, d'aluminium, de gallium et d'azote, ou par épitaxie par jet moléculaire à partir de sources élémentaires comprenant de l'indium, de l'aluminium, du gallium et de l'azote.

Les puits quantiques 21, 22, 23 se forment à la surface de la couche de transport d'électrons 10. En fonction des températures T1, T2, T3, les puits quantiques 21, 22, 23 comprennent une concentration plus ou moins importante d'indium.

En effet, l'incorporation d'indium dans une couche est fonction de la température d'élaboration de cette couche : plus cette température d'élaboration est faible, plus la quantité d'indium incorporée est importante ; à l'inverse, plus la température d'élaboration est forte plus la quantité d'indium incorporée est faible.

Du fait de leurs concentrations différentes en indium, les puits quantiques 21, 22, 23 émettent des lumières de couleurs différentes.

On obtient ainsi une pluralité de puits quantiques adjacents de concentrations en indium différentes émettant des rayonnements lumineux à des longueurs d'ondes différentes.

Une couche de blocage des électrons (EBL) 26 dopée p est déposée sur l'ensemble de puits quantiques 20 (étape 230). Cette couche de blocage des électrons est par exemple une couche de nitrure de gallium et d'aluminium dopée p p-AlGaN. La couche de blocage des électrons 26 est déposée soit par épitaxie en phase vapeur aux organométalliques (EPVOM), soit par épitaxie par jet moléculaire (EJM).

Une couche de transport de trous 30 dopée p est déposée sur la couche de blocage des électrons (étape 230). Cette couche de transport de trous 30 est par exemple une couche de nitrure de gallium dopée p p-GaN. La couche de transport de trous 30 est déposée soit par épitaxie en phase vapeur aux organométalliques (EPVOM), soit par épitaxie par jet moléculaire (EJM).

Une autre étape du procédé consiste à réaliser les contacts métalliques (étape 240) de la diode pour permettre sa connexion à une source d'alimentation électrique. Un contact 60 est réalisé (par exemple sur la face arrière du substrat. Un autre contact métallique 70 est réalisé sur la face avant de la couche de transport de trous 30.

### 3. Exemples et résultats

Une série de croissances de puits quantiques a été réalisée pour démontrer la validité du concept de variation de température à la surface d'un substrat du fait de la présence de vide au niveau de la face arrière du substrat.

Comme indiqué ci-dessus, la composition de l'alliage InxGa1-xN est très sensible à la température de croissance : dans des conditions de flux identiques, la teneur en indium sera d'autant plus grande que la température d'épitaxie est basse.

La température du substrat est obtenue principalement par le contact avec le suscepteur chaud, donc s'il n'y a pas de contact (entre le suscepteur et le substrat) localement on obtient des points froids.

Dans cette étude, des substrats composés chacun d'un film de nitrure de gallium GaN (polaire ou semipolaire) sur une plaque de saphir ont été utilisés.

Des substrats servant de témoins n'ont pas été préparés. D'autres ont été préparés de manière à obtenir un motif de bandes de silice :
- de 1µm d'épaisseur sur leur face arrière,
- de 2µm d'épaisseur sur leur face arrière.

Des structures de puits quantiques ont été élaborées sur ces substrats.

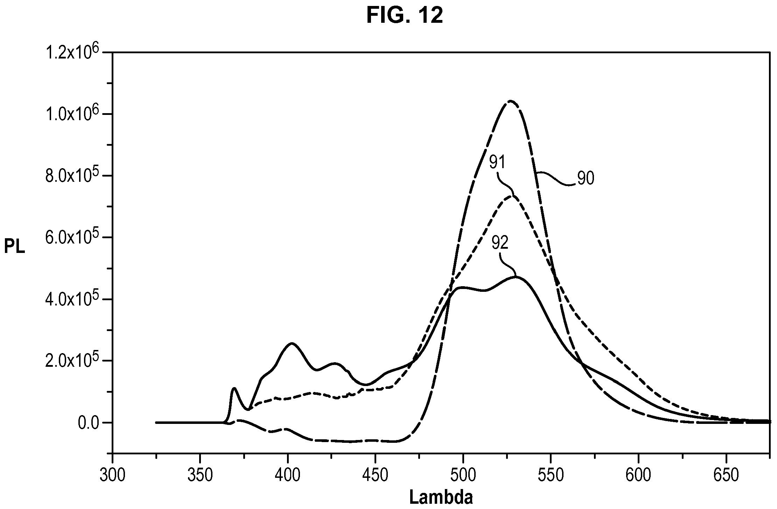

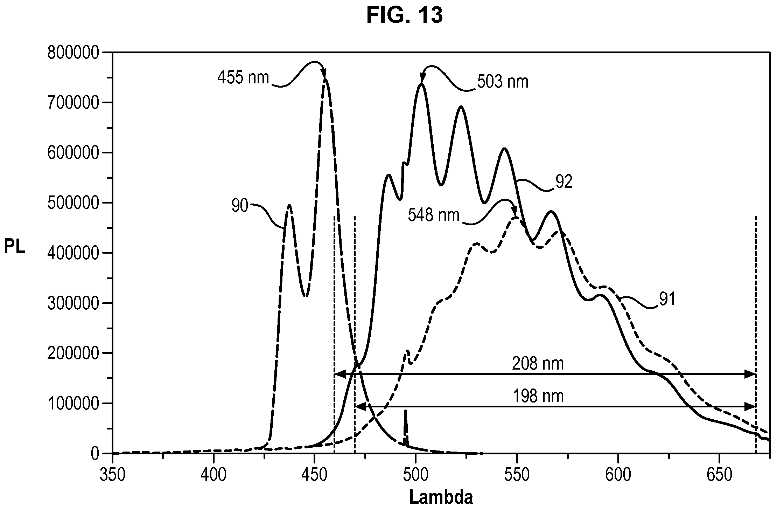

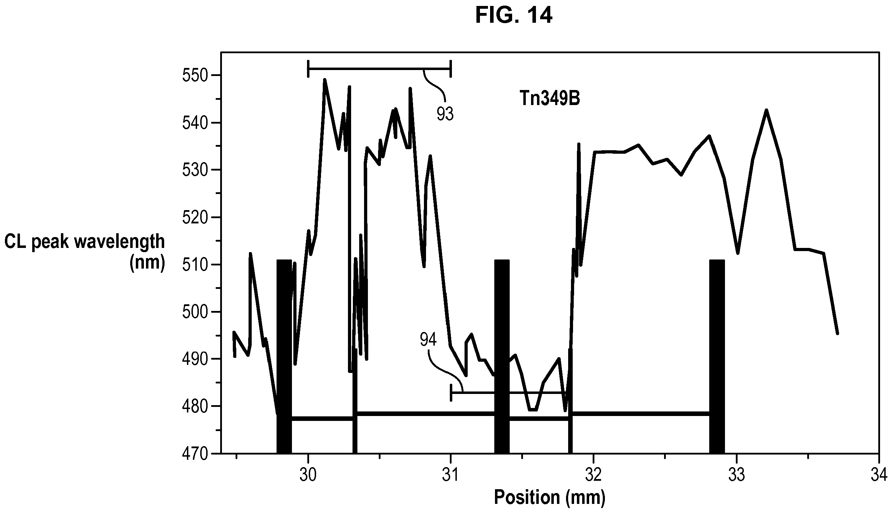

Des caractérisations par photoluminescence (cf. figures 12 et 13) et par cathodoluminescence (cf. figure 14) ont été mises en œuvre.

La figure 12 illustre le spectre de photoluminescence obtenu pour des substrats comprenant une couche de nitrure de gallium semi-polaire, et plus précisément pour :
- un substrat témoin (i.e. non préparé ne comprenant pas de motifs sur sa face arrière),
- un substrat préparé comprenant des bandes de SiO2 d'épaisseur 1µm sur sa face arrière,
- un substrat préparé comprenant des bandes de SiO2 d'épaisseur 2µm sur sa face arrière.

Une couche émettrice de lumière comprenant deux puits quantiques adjacents émettant des lumières de couleurs différentes a été formée sur chacun des substrats préparés.

On constate que le spectre 91 du substrat comportant des bandes de 1 µm est plus large que le spectre 90 du substrat témoin.

Le spectre 92 du substrat comportant des bandes de 2 µm est très large et présente deux zones de maximum dans le bleu-violet et dans le vert-jaune.

La figure 13 illustre le spectre de photoluminescence obtenu pour des substrats comprenant une couche de nitrure de gallium polaire, et plus précisément pour :
- un substrat témoin (i.e. non préparé ne comprenant pas de motifs sur sa face arrière),
- un substrat préparé comprenant des bandes de SiO2 d'épaisseur 1µm sur sa face arrière,
- un substrat préparé comprenant des bandes de SiO2 d'épaisseur 2µm sur sa face arrière.

Les spectres 91, 92 des deux substrats comportant des bandes sont plus larges que le spectre 90 du substrat témoin. Le spectre 92 du substrat comportant des bandes de 2 µm est plus intense.

Les spectres 91, 92 des deux substrats comportant des bandes sont centrés à des longueurs d'ondes plus élevées que le spectre 90 du substrat témoin, signe d'une température moyenne plus faible pendant la croissance.

Pour la caractérisation par cathodoluminescence, une série de spectres a été prise sur des puits polaires épitaxiés sur substrat saphir possédant des bandes en silice de 2 µm d'épaisseur sur la face arrière du substrat (la structure correspondant au spectre de photoluminescence 92 de la figure 13) en faisant varier la position du spot de quelques dizaines de µm (la plage de mesures représentée s'étend sur 4 mm).

Comme l'illustre la figure 14, on observe bien les deux plages 93, 94 de longueurs d'ondes des puits quantiques (déjà identifiées par photoluminescence).

Une alternance périodique est ainsi mise en évidence, correspondant aux différences de température locales de la plaque dues aux bandes de SiO₂ disposées sur la face arrière du substrat. Ces variations locales de longueurs d'onde sont abruptes, condition nécessaire pour obtenir une pluralité de longueurs d'onde à l'échelle des dimensions d'une diode, et donc obtenir une diode blanche.

Le procédé décrit ci-dessus permet la fabrication de diodes émettant à des lumières prédéterminées.

L'invention est seulement définie par les revendications ci-jointes.

## Revendications

1. Procédé de fabrication d'une diode électroluminescente, comprenant une étape d'élaboration (220) d'une couche émettrice de lumière (20) sur une face avant d'un support (50, 10), ladite couche émettrice comprenant au moins trois puits quantiques adjacents (21, 22, 23, 24) émettant à des longueurs d'ondes différentes, lesdits puits quantiques (21, 22, 23, 24) étant en contact avec la face avant du support comprenant un substrat dans lequel l'étape de dépôt de la couche émettrice de lumière comprend une sous-étape consistant à faire varier localement la température d'une face arrière du support opposée à la face avant de sorte que la face avant du support comporte au moins trois zones à des températures différentes, la variation de la température locale du support étant réalisée sur des zones d'épaisseurs différentes du substrat.

2. Procédé selon l'une quelconque des revendications 1 dans lequel l'étape de dépôt de la couche émettrice comprend une sous-étape consistant à faire croître chaque puits quantique sur une zone respective.

3. Procédé selon l'une des revendications 1 à 2, dans lequel la sous-étape consistant à faire varier localement la température de chauffage du support consiste à chauffer le support sous sa face arrière, ledit support incluant au moins un îlot sur sa face arrière.

4. Procédé selon l'une des revendications précédentes, lequel comprend une étape de préparation du support consistant à réaliser au moins un motif sur la face arrière du support.

5. Procédé selon la revendication 4, dans lequel l'étape de préparation du support consiste à réaliser une pluralité de motifs pour obtenir un support présentant une face arrière crénelée incluant des marches.

6. Procédé selon la revendication 4, dans lequel l'étape de préparation du support consiste à réaliser une pluralité de motifs pour obtenir un support présentant une face arrière crénelée incluant des marches d'épaisseurs et/ou de surfaces différentes.

7. Procédé selon la revendication 4, dans lequel l'étape de préparation comprend la gravure du support sur sa face arrière pour créer au moins une tranchée.

8. Procédé selon la revendication 4, dans lequel l'étape de préparation comprend le dépôt d'un matériau sur la face arrière du support de sorte à créer au moins un îlot sur la face arrière du support.

9. Procédé selon l'une des revendications précédentes, comprenant :
- le dépôt (210) d'une couche de transport d'électrons (10) sur un substrat (50),
- le dépôt (230) d'une couche de blocage des électrons (26) sur la couche émettrice de lumière (20),
- le dépôt (230) d'une couche de transport de trous (30) sur la couche de blocage des électrons (26),
- la formation de contacts métalliques (60, 70) pour permettre la connexion de la diode à une source d'alimentation électrique.

10. Procédé selon la revendication 2, dans lequel la croissance de chaque puits quantique est réalisée par :
- épitaxie en phase vapeur aux organométalliques à partir de précurseurs gazeux d'indium, d'aluminium, de gallium et d'azote, ou par
- épitaxie par jet moléculaire à partir de sources élémentaires comprenant de l'indium, de l'aluminium, du gallium et de l'azote.

11. Diode électroluminescente, comprenant une couche émettrice de lumière (20) sur une face avant d'un support (50, 10), ladite couche émettrice comprenant au moins trois puits quantiques adjacents (21, 22, 23, 24) émettant à des longueurs d'ondes différentes, lesdits puits quantiques (21, 22, 23, 24) étant en contact avec la face avant du support (50, 10) dans laquelle le support comprend un substrat incluant des motifs sur sa face arrière formant des zones d'épaisseurs différentes, la couche émettrice s'étendant sur la face avant du substrat.

12. Diode électroluminescente selon la revendication précédente, dans laquelle le support comprend un substrat de nitrure de gallium GaN.

13. Diode électroluminescente selon l'une des deux revendications précédentes, dans laquelle le support comprend un substrat de nitrure de gallium GaN semipolaire ou non-polaire.

14. Diode électroluminescente selon l'une des trois revendications précédentes, laquelle comprend une couche métallique formant cathode sur toute la surface de la face arrière de la diode.

## Patentansprüche

1. Verfahren zum Herstellen einer Leuchtdiode, das einen Schritt des Aufbauens (220) einer lichtemittierenden Schicht (20) auf einer Vorderseite eines Trägers (50, 10) umfasst, wobei die emittierende Schicht mindestens drei benachbarte Quantenmulden (21, 22, 23, 24) umfasst, die bei verschiedenen Wellenlängen emittieren, wobei die Quantenmulden (21, 22, 23, 24) in Kontakt mit der Vorderseite des Trägers sind, der ein Substrat umfasst, wobei der Schritt des Absetzens der lichtemittierenden Schicht einen Teilschritt des lokalen Variierens der Temperatur einer Rückseite des Trägers gegenüber der Vorderseite umfasst, so dass die Vorderseite des Trägers mindestens drei Zonen mit unterschiedlichen Temperaturen aufweist, wobei das Variieren der lokalen Temperatur des Trägers auf Zonen mit unterschiedlichen Dicken des Substrats erfolgt.

2. Verfahren nach Anspruch 1, wobei der Schritt des Absetzens der emittierenden Schicht einen Teilschritt des Aufwachsenlassens jeder Quantenmulde auf einer jeweiligen Zone umfasst.

3. Verfahren nach einem der Ansprüche 1 bis 2, wobei der Teilschritt des lokalen Variierens der Heiztemperatur des Trägers das Erhitzen des Trägers unter seiner Rückseite beinhaltet, wobei der Träger mindestens eine Insel auf seiner Rückseite einschließt.

4. Verfahren nach einem der vorherigen Ansprüche, das einen Schritt des Vorbereitens des Trägers durch Herstellen mindestens eines Musters auf der Rückseite des Trägers umfasst.

5. Verfahren nach Anspruch 4, wobei der Schritt des Vorbereitens des Trägers das Herstellen einer Vielzahl von Mustern beinhaltet, um einen Träger mit einer zinnenförmigen Rückseite zu erhalten, die Stufen einschließt.

6. Verfahren nach Anspruch 4, wobei der Schritt des Vorbereitens des Trägers das Herstellen einer Vielzahl von Mustern beinhaltet, um einen Träger mit einer zinnenförmigen Rückseite zu erhalten, die Stufen mit unterschiedlichen Dicken und/oder Oberflächen einschließt.

7. Verfahren nach Anspruch 4, wobei der Vorbereitungsschritt das Ätzen des Trägers auf seiner Rückseite umfasst, um mindestens einen Graben zu erzeugen.

8. Verfahren nach Anspruch 4, wobei der Schritt des Vorbereitens das Absetzen eines Materials auf der Rückseite des Trägers umfasst, um mindestens eine Insel auf der Rückseite des Trägers zu erzeugen.

9. Verfahren nach einem der vorherigen Ansprüche, das Folgendes umfasst:
- Absetzen (210) einer Elektronentransportschicht (10) auf einem Substrat (50),
- Absetzen (230) einer Elektronensperrschicht (26) auf der Licht emittierenden Schicht (20),
- Absetzen (230) einer Lochtransportschicht (30) auf der Elektronensperrschicht (26),
- Bilden von metallischen Kontakten (60, 70), um den Anschluss der Diode an eine Stromversorgungsquelle zu ermöglichen.

10. Verfahren nach Anspruch 2, wobei das Aufwachsenlassen jeder Quantenmulde erfolgt durch:
- organometallische Gasphasenepitaxie auf der Basis von gasförmigen Vorläufern von Indium, Aluminium, Gallium und Stickstoff, oder durch
- Molekularstrahlepitaxie auf der Basis von elementaren Quellen, die Indium, Aluminium, Gallium und Stickstoff umfassen.

11. Leuchtdiode, die eine lichtemittierende Schicht (20) auf einer Vorderseite eines Trägers (50, 10) umfasst, wobei die emittierende Schicht mindestens drei benachbarte Quantenmulden (21, 22, 23, 24) umfasst, die bei verschiedenen Wellenlängen emittieren, wobei die Quantenmulden (21, 22, 23, 24) in Kontakt mit der Vorderseite des Trägers (50, 10) sind, wobei der Träger ein Substrat umfasst, das auf seiner Rückseite Muster einschließt, die Zonen unterschiedlicher Dicke bilden, wobei sich die emittierende Schicht über die Vorderseite des Substrats erstreckt.

12. Leuchtdiode nach dem vorhergehenden Anspruch, wobei der Träger ein Galliumnitrid GaN-Substrat umfasst.

13. Leuchtdiode nach einem der beiden vorhergehenden Ansprüche, wobei der Träger ein semipolares oder unpolares Galliumnitrid GaN-Substrat umfasst.

14. Leuchtdiode nach einem der drei vorhergehenden Ansprüche, welche eine Metallschicht umfasst, die über die gesamte Fläche der Rückseite der Diode eine Kathode bildet.

## Claims

1. A method for fabricating a light-emitting diode, comprising a step of preparing (220) a light-emitting layer (20) on a front face of a support (50, 10), said emitting layer comprising at least three adjacent quantum wells (21, 22, 23, 24) emitting at different wavelengths, said quantum wells (21, 22, 23, 24) being in contact with the front face of the support, comprising a substrate, wherein the step of depositing the light-emitting layer comprises a sub-step consisting in locally varying the temperature of a back face of the support opposite to the front face such that the front face of the support comprises at least three areas at different temperatures, the local temperature variation of the support being carried out on areas of different thicknesses of the substrate.

2. The method according to claim 1, wherein the step of depositing the emitting layer comprises a sub-step consisting in growing each quantum well on a respective area.

3. The method according to one of claims 1 to 2, wherein the sub-step consisting in locally varying the heating temperature of the support consists in heating the support under its back face, said support including at least one island on its back face.

4. The method according to any one of the preceding claims, which comprises a step of preparing the support consisting in creating at least one pattern on the back face of the support.

5. The method according to claim 4, wherein the step of preparing the support consists in creating a plurality of patterns to obtain a support with a crenelated back face including steps.

6. The method according to claim 4, wherein the step of preparing the support consists in creating a plurality of patterns to obtain a support with a crenelated back face including steps of different thicknesses and/or surface areas.

7. The method according to claim 4, wherein the preparation step comprises the etching of the support on its back face to create at least one trench.

8. The method according to claim 4, wherein the preparation step comprises the deposition of a material on the back face of the support so as to create at least one island on the back face of the support.

9. The method according to any one of the preceding claims, comprising:
- the deposition (210) of an electron transport layer (10) on a substrate (50),
- the deposition (230) of an electron blocking layer (26) on the light-emitting layer (20),
- the deposition (230) of a hole transport layer (30) on the electron blocking layer (26),
- the formation of metal contacts (60, 70) to allow the connection of the diode to an electrical power source.

10. The method according to claim 2, wherein the growth of each quantum well is achieved by:
- organometallic vapour-phase epitaxy from gas precursors of indium, aluminium, gallium and nitrogen, or by
- molecular beam epitaxy from elementary sources comprising indium, aluminium, gallium and nitrogen.

11. Light-emitting diode comprising a light-emitting layer (20) on a front face of a support (50, 10), said emitting layer comprising at least three adjacent quantum wells (21, 22, 23, 24) emitting at different wavelengths, said quantum wells (21, 22, 23, 24) being in contact with the front face of the support (50, 10), wherein the support comprises a substrate including patterns on its back face forming areas of different thicknesses, the emitting layer extending over the front face of the substrate.

12. Light-emitting diode according to the previous claim, wherein the support comprises a gallium nitride GaN substrate.

13. Light-emitting diode according to one of the two previous claims, wherein the support comprises a semipolar or nonpolar gallium nitride GaN substrate.

14. Light-emitting diode according to one of the three previous claims, which comprises a metal layer forming a cathode over the whole surface of the back face of the diode.
